Europäisches Patentamt

European Patent Office

Office européen des brevets

(11) Publication number: **0 161 027**
**A2**

## (12) EUROPEAN PATENT APPLICATION

(21) Application number: **85200631.1**

(22) Date of filing: **24.04.85**

(51) Int. Cl.⁴: **H 03 G 3/20**
**H 04 B 1/04**

(30) Priority: **08.05.84 GB 8411640**

(43) Date of publication of application:
**13.11.85 Bulletin 85/46**

(84) Designated Contracting States:
**CH DE FR GB LI**

(71) Applicant: **PHILIPS ELECTRONIC AND ASSOCIATED INDUSTRIES LIMITED**
**Arundel Great Court 8 Arundel Street**
**London WC2R 3DT(GB)**

(84) Designated Contracting States:
**GB**

(71) Applicant: **N.V. Philips' Gloeilampenfabrieken**
**Groenewoudseweg 1**
**NL-5621 BA Eindhoven(NL)**

(84) Designated Contracting States:
**CH DE FR LI**

(72) Inventor: **Claydon, Martin**
**PYE TELECOMMUNICATIONS LIMITED St. Andrews Road**
**Cambridge CB4 1DW(GB)**

(74) Representative: **Moody, Colin James et al,**
**Philips Electronic and Associated Industries Limited**
**Patent Department Mullard House Torrington Place**
**London WC1E 7HD(GB)**

(54) Power control for radio transmitters.

(57) "Power Control for Radio Transmitters"

In radio transmitters, particularly mobile transmitters, it is necessary to regulate the output power in respect of temperature variations, supply voltage variations and operating frequency variations. If the r.f. power amplifier (14) is connected to a matched load then by monitoring the output power at the output of the power amplifier (14) is sufficient. However in the event of a mismatch due to a fault then a standing wave is set up between the power amplifier (14) and the fault. If a voltage null occurs near the monitoring point then the power amplifier (14) can be driven hard-on causing permanent damage to or the destructive breakdown of the power transistors.

However this disadvantage is avoided if the output power is monitored at two points (42, 44) separated by substantially $[((2n+1)/2)\pi]$ radians where $n$ is zero or a positive integer, at the band centre frequency, and either the higher or the mean of the monitored readings used to control the drive to the power amplifier (14). Preferably $n$ is zero so that the bandwidth over which power control can be exercised can be the greatest.

Fig. 2.

Croydon Printing Company Ltd.

0161027

## Power Control for Radio Transmitters

The present invention relates to power control for radio transmitters, particularly but not exclusively, mobile radio transmitters.

In present day technical specifications for mobile transmitters there is a requirement for output power control to take into account temperature changes, alterations in operating frequency and supply voltage variations. Known mobile transmitters detect the power at a single point at the output of the r.f. power amplifier and use the output power indication obtained in a power control circuit which applies a regulating signal to the r.f. driver stages. This type of system is satisfactory in the case of a matched aerial system but could lead to permanent damage to, or even permanent breakdown of, the output transistors in the r.f. power amplifier if a mismatch occurs due to, for example, an open circuit if say the aerial is damaged, or a short circuit if say the aerial feeder cable is crushed. The problem is particularly acute if the remaining feeder approximates to a multiple of a quarter wavelength ($\lambda/4$) and a standing wave is set-up so that the output voltage detector detects a null. The power control circuit on detecting the null causes a regulating signal to be applied to the r.f. driver stages to increase the drive to the r.f. power amplifier. Under a combination of maximum drive and worst case load, the transistor(s) in the r.f. power amplifier can be placed in a non-survivable over-dissipation condition which occurs too rapidly to be detected by outside temperature increase.

It is an object of the present invention to reduce the drive power of a transmitter in the event of a sudden mismatch occurring.

According to one aspect of the present invention there is provided a method of controlling the output power of a radio transmitter comprising monitoring the output voltage at points separated in phase by substantially $[((2n+1)/2)\pi]$ radians, where $n$ is zero or a positive integer, at the centre of the frequency band of the transmitter, and using at least the greater of the two monitored output voltages to provide a feedback signal for
controlling the transmitter output power.

If desired both said monitored output voltages may be combined
and a signal which is a proportion of said combined voltages is
used to provide said feedback signal.

According to the another aspect of the present invention there
is provided an output power control circuit for a radio
transmitter, comprising an r.f. driver stage coupled to an r.f.
power amplifier, the control circuit comprising means coupled to
the r.f. power amplifier for producing at least two outputs
separated in phase by substantially $[((2n+1)/2)\pi]$ radians, where $n$
is 0 or a positive integer, at the centre of the frequency band of
the transmitter, and means for determining which of the two outputs
is the greater and using this output to produce a feedback signal
which is applied to the r.f. driver stage.

According to a further aspect of the present invention there
is provided an output power control circuit for a radio transmitter
comprising an r.f. driver stage coupled to an r.f. power amplifier,
said control circuit comprising means coupled to said r.f. power
amplifier for producing at least two outputs separated in phase by
substantially $[((2n+1)/2)\pi]$, where $n$ is 0 or a positive integer,
at the centre of the frequency band of the transmitter, and means
for combining said outputs and deriving a signal which is a
proportion of the two combined outputs and using this signal to
produce a feedback signal which is applied to the r.f. driver
stage.

Although the two outputs may be separated in phase by several
odd multiples of $\pi/2$ radians it has been found advantageous to
keep the value of $n$ low to have a reasonable usable bandwidth.  For
$n=0$ the best usable bandwidth is obtained.

The phase separation means coupled to the output of the r.f.
power separation means may comprise a predetermined length of
transmission line or the lumped circuit equivalent (in phase shift)
thereof.  One advantage of using the lumped circuit equivalent is
that it acts as a low pass filter which means that in the case of a transceiver operating in simplex mode in which a change-over relay (or the electronic equivalent thereof) is connected to the transmitter and receiver, a smaller harmonic filter can be connected between the change-over relay and the antenna.

The output determining means may comprise peak diode detectors coupled to an input and an output of the phase separation means. Such an arrangement is simple to implement and operates on the basis that the higher of the signals at the input and the output of the phase separation means is used to produce the feedback signal. If desired the signals at the input and output of the phase separation means may be processed independently to provide an indication of a fault, for this purpose an additional diode detector at a position $\pi/4$ radians phase shifted with respect to one of the original detectors would be particularly useful.

According to yet another aspect of the present invention there is provided a radio transmitter comprising an r.f. driver stage, an r.f. power amplifier coupled to the r.f. driver stage, phase shifting means coupled to the r.f. power amplifier for producing a phase shift of $[((2\underline{n}+1)/2)\pi]$ radians at the band centre frequency, deriving the r.f. voltages at the input and at the output of the phase shifting means and applying at least the greater one of said voltages to a power control circuit coupled to the r.f. driver stage to regulate the power amplifier output accordingly.

The present invention will now be explained and described, by way of example, with reference to the accompanying drawings, wherein:

Figure 1 is a block schematic diagram of a known transceiver having output power control on the transmitter,

Figure 2 is a block schematic circuit diagram of a transceiver having an output power control circuit made in accordance with the present invention,

Figure 3 is a schematic circuit diagram of a quarter wave line whose input and output are connected respectively to two diode detectors,

Figure 4 is a schematic circuit diagram of a lumped equivalent circuit whose input and output are connected respectively to two diode detectors, and,

Figure 5 shows a waveform of a typical voltage standing wave pattern.

In the drawing corresponding reference numerals have been used to indicate the same features.

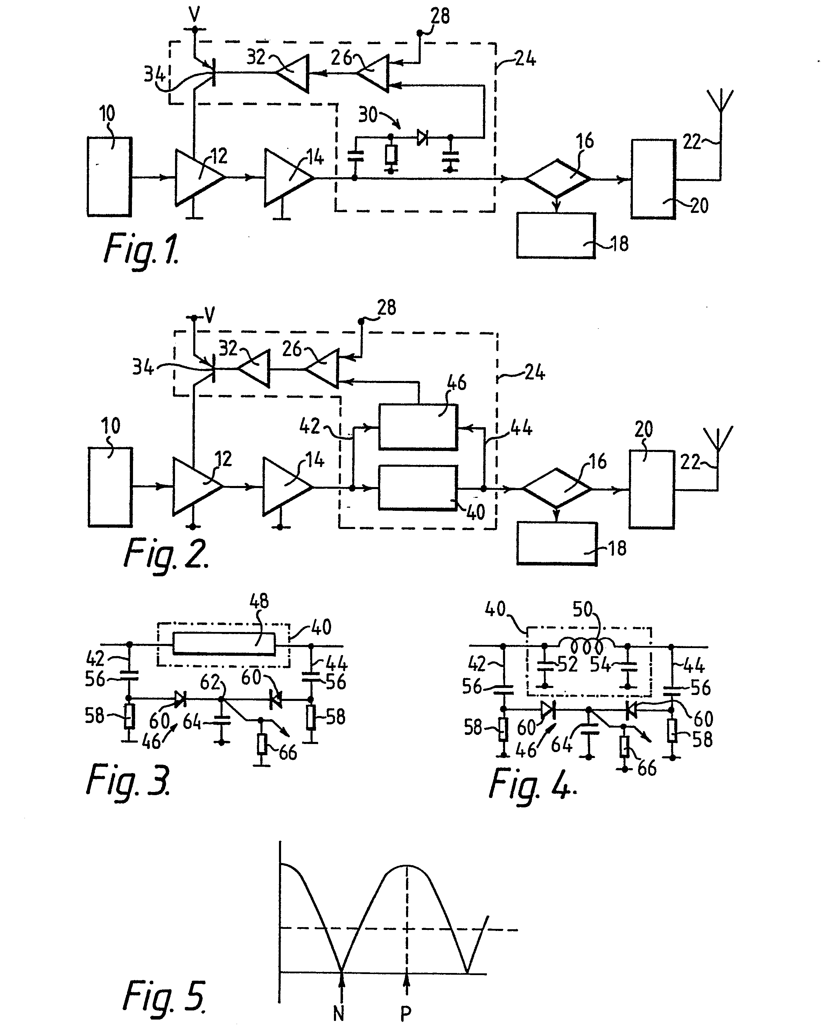

Referring to Figure 1, the known transceiver comprises a master oscillator and modulator 10 whose output is coupled to r.f. driver stages 12 which in turn are connected to the final r.f. power amplifier 14. The output of the power amplifier 14 is connected to an aerial change-over relay 16 having outputs connected to a receiver section 18 and a harmonic filter 20. An antenna 22 is connected to the harmonic filter 20. The filter 20 is necessary to remove harmonics generated in the relay 16. The operation of the transceiver described so far is well known in the sense that in the receive mode, the relay 16 connects the antenna 22 to the receiver section 18 and in the transmit mode the power amplifier 14 is connected by the relay 16 to the antenna 22.

The transmitter section of the transceiver includes a power control circuit 24 which comprises a comparator 26 having one input connected to a d.c. voltage source (not shown) connected to an input terminal 28 and another input connected to a diode detector 30 connected to the output of the power amplifier 14. The comparator 26 is coupled via a buffer amplifier 32 to the base electrode of a p-n-p junction transistor 34 whose collector is connected to the driver stages 12 to control the drive therefrom. If the output of the power amplifier 14 increases then the power control circuit 24 reduces the drive to the stages 12. Conversely the drive is increased, when the output power decreases.

This known system is satisfactory provided the antenna 22 is correctly matched. However if a mismatch occurs due to an open circuit, e.g. a broken antenna, or a short circuit, e.g. a crushed antenna feeder, then a standing wave is created between the power amplifier 14 and the fault. If a voltage null should occur close to the diode detector 20 then the power control circuit 24 sees that the output power is low and causes it to apply a maximum control voltage to the driver stages 12. Under the combination of maximum drive and worst case load, transistors in the power amplifier 14 can be placed in a non-survivable over-dissipation condition which happens too quickly to detect by outside temperature rise.

In the embodiment of the present invention illustrated in Figure 2, this problem is resolved by monitoring the r.f. voltage at two points which are separated in phase by substantially $[((2n+1)/2)\pi]$ radians, where $n$ is zero or a positive integer, at the band centre frequency of the transmitter. Preferably $n$ is zero to obtain the widest usable bandwidth. The voltages at these two points are detected and the larger one is applied to a comparator 26 in which it is compared with a d.c. voltage applied to the terminal 28. As shown in Figure 5, at the band centre frequency, if a null N occurs at one of the two points being monitored then a peak P occurs $\lambda/4$ from the null N which corresponds to a phase shift of $\pi/2$. Thus at no time can a null N be used to control the output power of the transmitter.

Compared to Figure 1, the embodiment of the invention does not have a single diode detector 30 but instead has phase shifting or separating means 40 for producing an output 44 which is shifted or separated in phase by substantially $[((2n+1)/2)\pi]$ radians relative to its input 42 and detection means 46 for providing a voltage related to the greater of the voltages on the input 42 and output 44, which voltage is applied to the comparator 26.

Assuming that the output impedance of the power amplifier is 50ohms and the input 42 and output 44 are separated by $\pi/2$ radians then as shown in Figures 3 and 4 the phase shifting means 40 comprises a length 48 of 50 ohm aerial feeder corresponding to a quarter wavelength at the band centre frequency or a lumped circuit equivalent thereof comprising an inductance 50 and two shunt capacitors 52, 54, the impedance of each of which is 50ohms at the band centre frequency of the transmitter. As the lumped circuit equivalent (Figure 4) also serves as a filter then the harmonic filter 20 need not be as large compared to the case when the length of aerial feeder is used.

In both cases the detection means is the same, namely two diode detectors connected to a common junction 62, each detector being formed by a capacitor 56, a resistor 58 and a diode 60 having its anode connected to a junction of the capacitor 56 and the resistor 58 and its cathode connected to the junction 62. A capacitor 64 is connected to the junction 62 from which a voltage to be applied to the comparator 26 is derived. A biasing resistor 66 is connected to the line from the junction 62, this resistor may comprise a part of the comparator 26.

The value of the capacitors 56 is low to minimise loading the output of the power amplifier 14. The resistor 58 constitutes a bias resistor and is better and cheaper than an inductance which is prone to r.f. pick-up. The diodes 60 are ideally matched Schottky diodes.

In operation the higher of the voltages on the input 42 and output 44 causes one of the diodes to be conductive and the other of the diodes to be non-conductive (reversed biased) and a voltage is built-up on the capacitor 64, which voltage is applied to its respective input of the comparator 26. Thereafter the circuit behaves as the power control circuit described with reference to Figure 1.

Although not shown, each voltage on the input 42 and output 44 could be processed separately and could be used to provide an indication of an antenna system fault especially if a third diode detector is additionally connected at a point phase shifted by $\pi/4$ radians from either of the original detectors.

In another, non-illustrated embodiment of the present invention which is more suited to broadband operation the voltages on the input 42 and the output 44 are derived separately and combined in a summing network. A proportion of the summed voltage, for example the mean of the two voltages, is then applied to the comparator 24 and compared with a fixed d.c. voltage as described previously.

PHB 33079 .EP

**0161027**

The implementation of this non-illustrated embodiment can be readily understood if reference is made to Figures 3 or 4. Capacitor 64 is omitted and instead a capacitor is connected between the cathode of each of the diodes 60 and ground. Also equal value resistors are connected between each of the cathodes of the diodes 60 and the junction 62 which serves as a summing junction. The value of the summing resistors is greater than that of the resistor 66, the value of which is selected to get the desired feedback.

## Claims

1.  A method of controlling the output power of a radio transmitter characterised by monitoring the output voltage at points separated in phase by substantially $[((2n+1)/2)\pi]$ radians, where $\underline{n}$ is zero or a positive integer, at the centre of the frequency band of the transmitter, and using at least the greater of the monitored output voltages to provide a feedback signal for controlling the transmitter output power.

2.  A method as claimed in Claim 1, characterised in that diode detectors are used to determine which of the monitored output voltages is the greater.

3.  · A method as claimed in Claim 1, wherein both said monitored output voltages are combined, and a signal which is a proportion of said combined voltages is used to provide said feedback signal.

4.  A method as claimed in Claim 1, 2 or 3 characterised in that each of the two monitored output voltages is processed separately and are further used to provide an indication of an antenna system fault.

5.  An output power control circuit for a radio transmitter comprising an r.f. driver stage coupled to an r.f. power amplifier, characterised in that the control circuit includes means coupled to the r.f. power amplifier for producing at least two outputs separated in phase by substantially $[((2n+1)/2)\pi]$, where n is 0 or a positive integer, at the centre of the frequency band of the transmitter, and means for determining which of the two outputs is the greater and using this output to produce a feedback signal which is applied to the r.f. driver stage.

6.  A circuit as claimed in Claim 5, characterised in that the output determining means comprises peak diode detectors coupled to an input and output of said means for producing phase separated signals.

7.  A circuit as claimed in Claim 6, characterised in that there are provided a further peak diode detector connected to provide a signal phase shifted by $\pi/4$ from either one of the phase separated outputs of said peak diode detectors and means coupled to the peak diode detectors and the further peak diode detector for providing an indication of an antenna system fault.

8. An output power control circuit for a radio transmitter comprising an r.f. driver stage coupled to an r.f. power amplifier characterised in that the control circuit includes means coupled to the r.f. power amplifier for producing at least two outputs separated in phase by substantially $[((2n+1)/2\pi)]$, where n is 0 or a positive integer, at the centre of the frequency band of the transmitter, and means for combining said outputs and deriving a signal which is a proportion of the combined outputs and using this signal to produce a feedback signal which is applied to the r.f. driver stage.

9. A circuit as claimed in any one of Claims 5 to 8 characterised in that the phase separation means coupled to the output of the r.f. power amplifier comprises a predetermined length of transmission line or a lumped circuit equivalent (in phase shift) to said predetermined length of transmission line.

10. A radio transmitter comprising an r.f. driver stage, an r.f. power amplifier coupled to the r.f. driver stage, and a power control circuit coupled to the r.f. driver stage to regulate the power amplifier output, characterised in that there are provided phase shifting means coupled to the r.f. power amplifier for producing a phase shift of substantially $[((2n+1)/2)\pi]$ radians at the band centre frequency, means for deriving the r.f. voltages at the input and at the output of the phase shifting means and applying at least the greater one of said voltages to the power control circuit whereby the power amplifier is regulated accordingly.

11. A radio transmitter as claimed in Claim 10, characterised in that the phase shifting means coupled to the r.f. power amplifier comprises a predetermined length of transmission line or a lumped circuit equivalent (in phase shift) to said predetermined length of transmission line.

12. A radio transmitter as claimed in Claim 10 or 11, characterised in that the r.f. voltage determining means comprises peak diode detectors coupled respectively to the input and output of the phase shifting means.

13.    A radio transmitter as claimed in Claim 12, characterised in that there are provided a further peak diode detector connected to provide a signal phase shifted by $\pi/4$ from either one of the phase separated outputs of said peak diode detectors and means coupled to the peak diode detectors and the further peak diode detector for providing an indication of an antenna system fault.

14.    A radio transmitter as claimed in any one of Claims 10 to 13, characterised by summing means for summing the r.f. voltages at the input and the output of the phase shifting means, and means for deriving a proportion of the summed voltages and applying it to said power control circuit.

Fig.1.

Fig.2.

Fig.3.

Fig.4.

Fig.5.